# EUROPEAN PATENT APPLICATION

(11) **EP 3 605 783 A1**
(43) Date of publication of application: **05.02.2020**
(21) Application number: 19188878.3
(22) Date of filing: 29.07.2019
(51) Int. Cl.: H02J 7/00, H01M 10/42

(54) **BATTERY MODULE WITH A VOLTAGE CONTROLLED SWITCH**

(30) Priority: 30.07.2018 US 201816049345
(71) Applicant: Hi-Cooler Company Limited, Mongkok, Kowloon (HK)
(72) Inventor: WONG, Ching, Kowloon (HK); CHAN, Ka Yun, Kowloon (HK)
(74) Representative: Iqbal, Md Mash-Hud

(57) **Abstract**

A battery module 20 including a rechargeable battery 32, a charging circuit 24 for the rechargeable battery; and a switch 28 adapted to connect the rechargeable battery to the charging circuit, or to output terminals of the battery system. The switch is adapted to change its switching status by a voltage applied to input terminals of the charging circuit. By de-centralizing the control of the switches in multiple battery modules, adding or removing a battery module from the group of battery modules becomes easy.

## Description

### FIELD OF INVENTION

This invention relates to an electrical energy storage device and in particular to a battery and its connection to a charging circuit.

### BACKGROUND OF INVENTION

Rechargeable batteries are used commonly in many aspects of human life for example on vehicles, power tools, toys, personal communication devices, etc. Usually, a charging circuit is configured for a battery when the battery is an integral part of an electrical appliance, so that whenever an external power supply is available (e.g. the mains electricity), then the electrical appliance could charge the battery as the electrical appliance at this time will be powered by the external power supply. It is also common to have multiple battery modules configured for a single electrical appliance so that requirements for higher voltage or higher current that cannot be provided by a single battery module can be satisfied.

However, for multiple battery modules in an electrical appliance the charging of the batteries / battery cells simultaneously poses some challenges. Conventionally, very sophisticated battery management circuits have been developed to handle charging and discharging cycle of the cells. These battery management circuits are often customized circuits and there is no flexibility provided to add or remove battery module(s) from the electrical appliance, since otherwise the battery management circuit will not be applicable to the battery system after the change. Therefore if one battery module has a defect, it always needs to replace all the battery modules in the electrical appliance.

### SUMMARY OF INVENTION

In the light of the foregoing background, it is an object of the present invention to provide an alternate battery module and battery system which eliminates or at least alleviates the above technical problems.

The above object is met by the combination of features of the main claim; the subclaims disclose further advantageous embodiments of the invention.

One skilled in the art will derive from the following description other objects of the invention. Therefore, the foregoing statements of object are not exhaustive and serve merely to illustrate some of the many objects of the present invention.

Accordingly, the present invention, in one aspect, is a battery module including a rechargeable battery, a charging circuit for the rechargeable battery; and a switch adapted to connect the rechargeable battery to the charging circuit, or to output terminals of the battery module. The switch is adapted to change its switching status by a voltage applied to input terminals of the charging circuit.

Preferably, the switch is a double-pole-double-throw (DPDT) type. Two input terminals of the switch connect to a positive terminal and a negative terminal of the rechargeable battery respectively. A first set of output terminals of the switch connects to the output terminals of the battery module. A second set of output terminals of the switch connects to output terminals of the charging circuit.

More preferably, the switch contains a relay with an input connected to the input terminals of the charging circuit.

Alternatively, the switch includes a transistor circuit with an input connected to the input terminals of the charging circuit.

According to a variation of the preferred embodiments, the switch is a single-pole-double-throw (SPDT) type. An input terminal of the switch connects to a positive terminal of the rechargeable battery. A first output terminal of the switch connects to one of the output terminals of the module. A second output terminal of the switch connects to one of the output terminals of the charging circuit. The battery module further contains a transistor coupled between a negative terminal of the rechargeable battery and another one of the output terminals of the charging circuit.

Preferably, the transistor is a PNP BJT or a P-channel MOSFET.

According to another variation of the preferred embodiments, the transistor is coupled with a Zener diode.

The present invention in another aspect provides a battery module including a plurality of battery modules similar to those mentioned above. Input terminals of a charging circuit in each battery module are connected to a common input. Output terminals of the plurality of battery modules are connected in series or parallel.

There are many advantages to the present invention. There is no complicated battery management unit in each battery module, rather a switch is controlled by a voltage applied to the charging circuit to place the battery into charging mode or into discharging mode. As such, the operations of multiple battery modules can be synchronized easily since the same charging voltage can be applied to the multiple charging circuits in the battery modules at the same time, therefore making the switches in all the battery modules to change status. Such a battery system has a low complexity and is less likely to suffer from malfunctioning.

Another advantage of the present invention is that by having common voltage lines for charging which serve as the signaling lines for multiple battery modules, the addition or removal of one or more battery modules from the battery system becomes easy. The addition or removal of a battery module does not interfere with the operation of other battery modules in the system at all, as the only requirement is to connect / disconnect a particular battery module from the common input and output terminals of the battery system. No other changes to the structures or connections of the battery system are required.

### BRIEF DESCRIPTION OF FIGURES

The foregoing and further features of the present invention will be apparent from the following description of preferred embodiments which are provided by way of example only in connection with the accompanying figures, of which:
Fig. 1 is a schematic diagram of a battery module according to one embodiment of the present invention.
Fig. 2 shows multiple battery modules connected in series according to another embodiment of the present invention.
Fig. 3 shows multiple battery modules connected in parallel according to another embodiment of the present invention.
Fig. 4 shows the schematic diagram of a battery module connected with a P-channel MOSFET according to another embodiment of the present invention.
Fig. 5 shows the schematic diagram of a battery module connected with a PNP transistor according to another embodiment of the present invention.
Fig. 6 shows the schematic diagram of a battery module connected with a P-channel MOSFET and a Zener diode according to another embodiment of the present invention.
Fig. 7 shows the schematic diagram of a battery module connected with a PNP transistor and a Zener diode according to another embodiment of the present invention.

In the drawings, like numerals indicate like parts throughout the several embodiments described herein.

### DETAILED DESCRIPTION OF THE PREFERRED EMBODIMENTS

In the claims which follow and in the preceding description of the invention, except where the context requires otherwise due to express language or necessary implication, the word "comprise" or variations such as "comprises" or "comprising" is used in an inclusive sense, i.e. to specify the presence of the stated features but not to preclude the presence or addition of further features in various embodiments of the invention.

As used herein and in the claims, "couple" or "connect" refers to electrical coupling or connection either directly or indirectly via one or more electrical means unless otherwise stated.

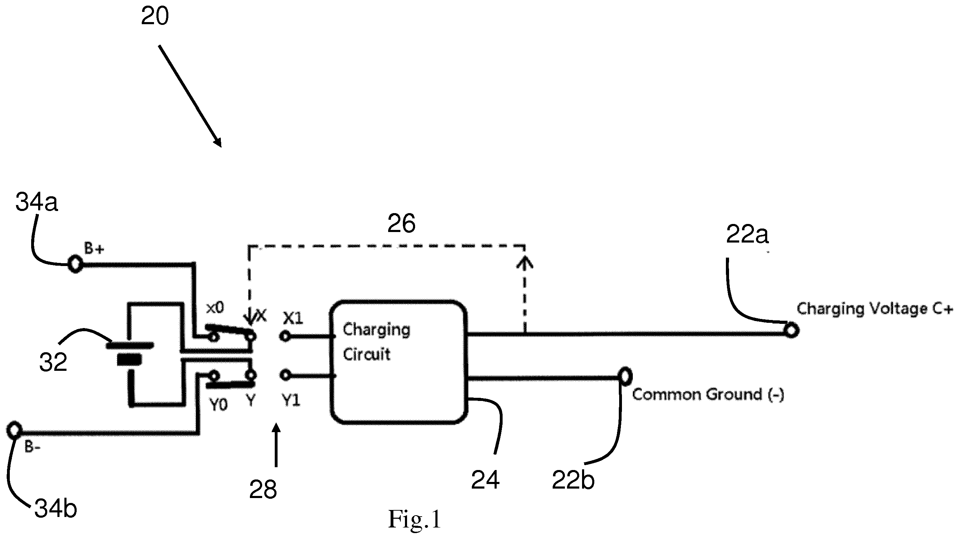

Referring now to Fig. 1, the first embodiment of the present invention is a battery module **20** that is capable of providing electrical power to an electrical appliance (not shown). The battery module **20** can be an integral part of the electrical appliance which is non-removable, or the battery module **20** can be in the form of a separate component removably connected to the electrical appliance, such as a battery pack. There are four terminals of the battery module **20** via which the battery module **20** can be connected to other circuits, components, and/or apparatus. In particular, input terminals **22a**, **22b** of a charging circuit **24** in the battery module **20** are also the input terminals of the battery module **20**. The input terminal **22a** is intended to connect to a positive charging voltage, and the input terminal **22b** is intended to connect to a common ground. Note that both the positive charging voltage and the common ground are not shown in Fig. 1, but they will be illustrated later in other drawings.

The charging circuit **24** is connected to a battery **32** via a switch **28**, subject to the status of the switch **28.** The switch **28** includes a pair of input terminals **X** and **Y**, which are connected to a positive terminal and a negative terminal of the battery **32** respectively. A first set of the output terminals **X1**, **Y1** are connected to respective output terminals of the charging circuit **24**. A second set of the output terminals **X0**, **Y0** are connected to output terminals **34a**, **34b** of the battery module **20.** The switch **28** is therefore a DPDT switch.

Also shown in Fig. 1 is a signal link **26** from the input terminals **22a**, **22b** to the switch **28.** The signal link **26** indicates a charging voltage applied to the charging circuit **24** also functioning as a signal to change the status of the switch **28.** In one implementation, the switch contains a relay controlled directly by the charging voltage. Alternatively, in another embodiment the switch **28** contains a transistor circuit configured as switches and controlled by the charging voltage to achieve the same result. It should be noted that in any event, there is no microcontroller(s) and bus connections for controlling the operation of the switch **28.**

Now turning to the operation of the device described above. Fig. 1 shows the status of the switch **28** when there is no charging voltage applied on the input terminal **22a** of the battery module **20.** In this status, the battery module **20** is kept at its discharging mode where the input terminals **X** and **Y** are in electrical connection with the second set of output terminals **X0** and **Y0**. As such, the battery **32** is directly connected with the output terminals **34a**, **34b** of the battery module **20**, so any loading such as an electrical appliance connected to the output terminals **34a**, **34b** can be powered by the battery **32.** However, when there is a positive charging voltage appearing on the input terminal **22a**, then the switch **28** changes its status because of the charging voltage, and in particular the input terminals **X** and **Y** of the switch **28** will no longer be in electrical connection with the second set of output terminals **X0** and **Y0**, but the input terminals **X** and **Y** will become connected with the first set of output terminals **X1** and **Y1.** In this way, the charging circuit **24** is now in connection with the battery **32**, and the battery **32** as it is now in a charging mode can be recharged, when necessary, by the charging circuit **24.** When the charging voltage at the input terminal **22a** disappears, then the switch **28** will change its status again, back to the status shown in Fig. 1 in which the battery **32** turns to the discharging mode.

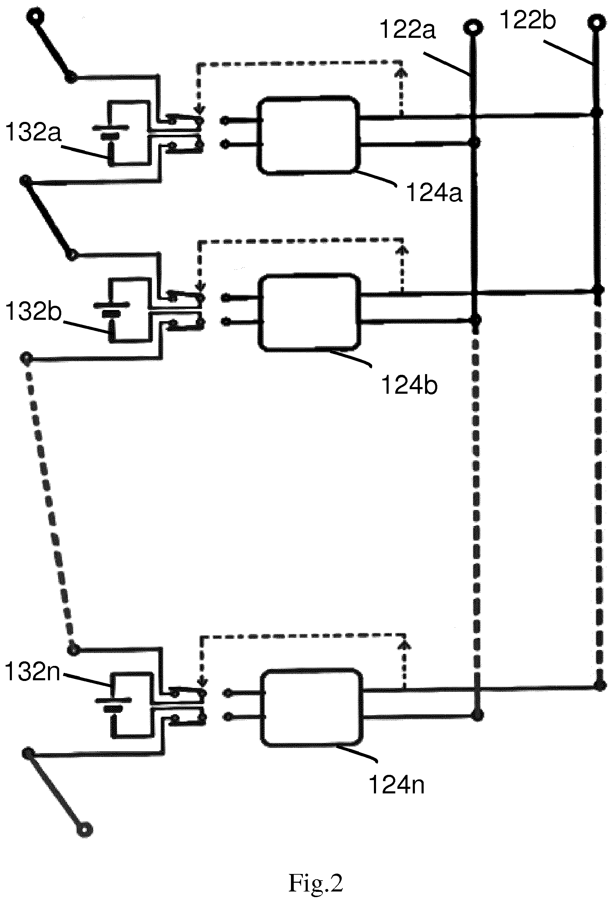

Fig. 2 shows *n* number of battery modules **124a**, **124b**, .... **124n** connected in series according to another embodiment of the invention. Each one of the battery modules **124a**, **124b**, .... **124n** has a structure similar to that shown in Fig .1. All the input terminals of the battery modules **124a**, **124b**, .... **124n** connect to two common lines, one being a common charging voltage line **122a** and the other one being a common ground line **122b.** Each one of the battery modules **124a**, **124b**, .... **124n** has a battery **132a**, **132b,** ... **132n**. As the battery modules **124a**, **124b**, .... **124n** are connected to each other in series at their output terminals, the batteries **132a**, **132b**, ... **132n** are able to output together a voltage equals to *n* times of a voltage outputted by a single battery module. Note that each one of the battery modules **124a, 124b,** .... **124n** can be switched between a discharging mode and a charging mode as described above, but their switching actions are synchronized since the same charging voltage is applied to all of the battery modules **124a**, **124b**, .... **124n** at the same time via the common charging voltage line **122a** and the common ground line **122b**. The disappearing of the charging voltage is also at the same time to each one of the battery modules **124a**, **124b**, .... **124n.**

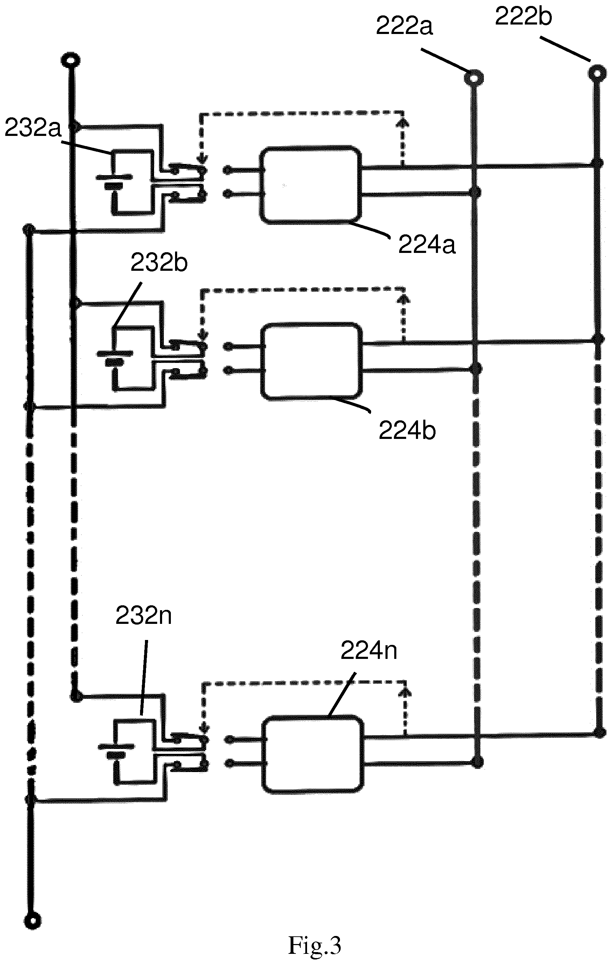

Fig. 3 shows *n* number of battery modules **224a**, **224b**, .... **224n** connected in series according to another embodiment of the invention. Each one of the battery modules **224a**, **224b**, .... **224n** has a structure similar to that shown in Fig .1. All the input terminals of the battery modules **224a**, **224b**, .... **224n** connect to two common lines, one being a common charging voltage line **222a** and the other one being a common ground line **222b**. Each one of the battery modules **224a**, **224b**, .... **224n** has a battery **232a**, **232b**, ... **232n.** As the battery modules **224a**, **224b**, .... **224n** are connected to each other in parallel at their output terminals, the batteries **232a**, **232b**, ... **232n** are able to output together a current equals to *n* times of a current outputted by a single battery module. Note that each one of the battery modules **224a**, **224b**, .... **224n** can be switched between a discharging mode and a charging mode as described above, but their switching actions are synchronized since the same charging voltage is applied to all of the battery modules **224a**, **224b**, .... **224n** at the same time via the common charging voltage line **222a** and the common ground line **222b**. The disappearing of the charging voltage is also at the same time to each one of the battery modules **224a**, **224b**, .... **224n**.

One can see that the above embodiments of the present invention provide an easy way of mounting or dismounting of a single battery module from the group of battery modules connected in series or in parallel. A dismounted battery module can then be easily repaired or maintained. Without a central controller, any battery module(s) can be conveniently mounted to the group of battery modules, or dismounted therefrom, without significantly interrupting the operation of the group of battery modules. This is therefore a de-centralized control of the switches in the battery modules. The control of the switch is done internally within every battery module. Whenever there is a good charging voltage appearing at the charging terminal, the switch will make the battery turning to charging mode. In this way, there is no limit of how many similar battery modules can be connected together. There is no any other limiting factor such as the system control main bus size, or system control module capacity. Also, it is easy to handle the charging and discharging cycle of the all the battery modules, since whenever there is a low charging voltage applying to the charging terminal, the group of battery modules will switch to a same switching status.

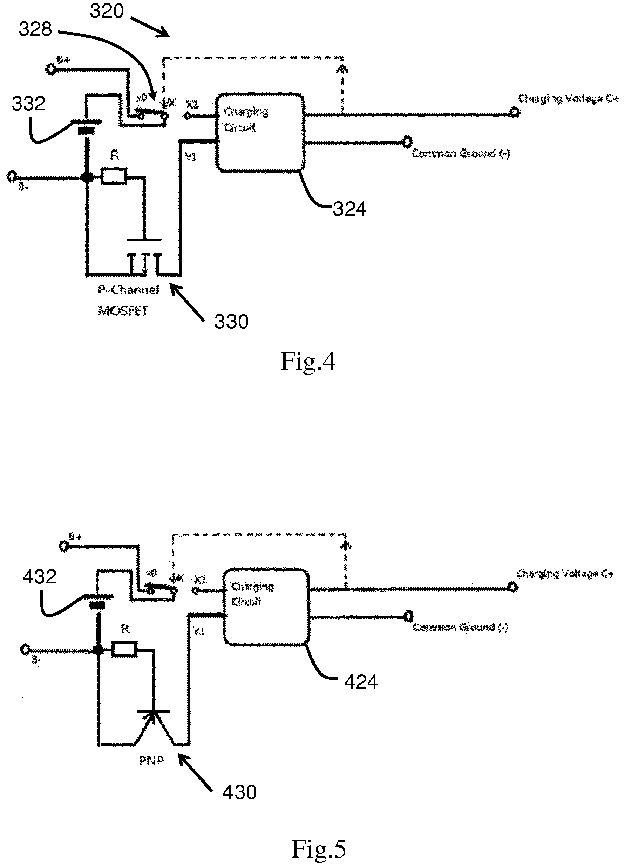

Turning now to Fig. 4, which shows a battery module **320** according to another embodiment of the invention. Please note that for the sake of brevity, only the difference of the battery module **320** as compared to the one in Fig. 1 will be described herein, while their common or identical parts will not be described. In the battery module **320**, instead of using a DPDT switch, a single-pole-double-throw (SPDT) switch **328** is used to couple the battery **332** to other components. In particular, a positive terminal of the battery **332** is connected to an input terminal X of the switch **328**. A first output terminal **X1** of the switch **328** is connected to the charging circuit **324**, and a second output terminal X0 is connected to the output terminal B+ of the battery module **320.** On the other hand, a negative terminal of the battery **332** is connected to a P-Channel MOSFET **330**, and in particular directly connected with the Source pin of the P-Channel MOSFET **330**, as well as connected with the Gate pin of P-Channel MOSFET **330** through a resistor R. A Drain pin of the P-Channel MOSFET **330** is connected to the charging circuit **324** at Y1.

During operation, the P-Channel MOSFET **330** is controlled by the connection status of the negative terminal of the battery **332.** When the negative terminal of the battery **332** is either not connected to a positive terminal of other battery modules (not shown), or is connected to a common ground, then the P-Channel MOSFET **330** is conducting, and hence the negative terminal of the battery **332** will be connected to the output terminal Y1 of the charging circuit **324.** Therefore, if the battery module **320** is connected to other battery modules in series (similar to the case shown in Fig. 2), then the negative terminal of battery **332** will only connect to Y1 when a positive terminal of an adjacent battery module is switched to the charging circuit of this adjacent battery module, thus not connecting to the negative terminal of the battery **332**. Otherwise, if the positive terminal of the adjacent battery module is in connected with the negative terminal of the battery 332, then the negative terminal of the battery **332** is isolated from the output terminal Y1 of the charging circuit **324**. In this way, even if only a SPDT switch **328** is configured in the battery module **320**, the negative terminal of the battery **332** can also be automatically switched over when the battery module **320** is connected with other battery modules in series.

However, if the battery module **320** is connected with other battery modules in parallel, then the negative terminal of battery **332** will always connect to the output terminal Y1 of the charging circuit **324**, since the negative terminal of battery **332** is connected always to a common ground.

Fig. 5 shows another embodiment of the invention in which the P-Channel MOSFET **330** is replaced by a Bipolar Junction Transistor (BJT) **430** which is of PNP type. All other components in the battery module are the same as those in Fig. 4, and they will not be described in further details here. A negative terminal of the battery **432** is directly connected with the Emitter pin of the BJT **430**, as well as connected with the Base pin of BJT **430** through a resistor R. A Collector pin of the BJT **430** is connected to the charging circuit **424**. The operation of the battery module in Fig. 5 is similar to that of the battery module in Fig. 4 so it will not be described in details here.

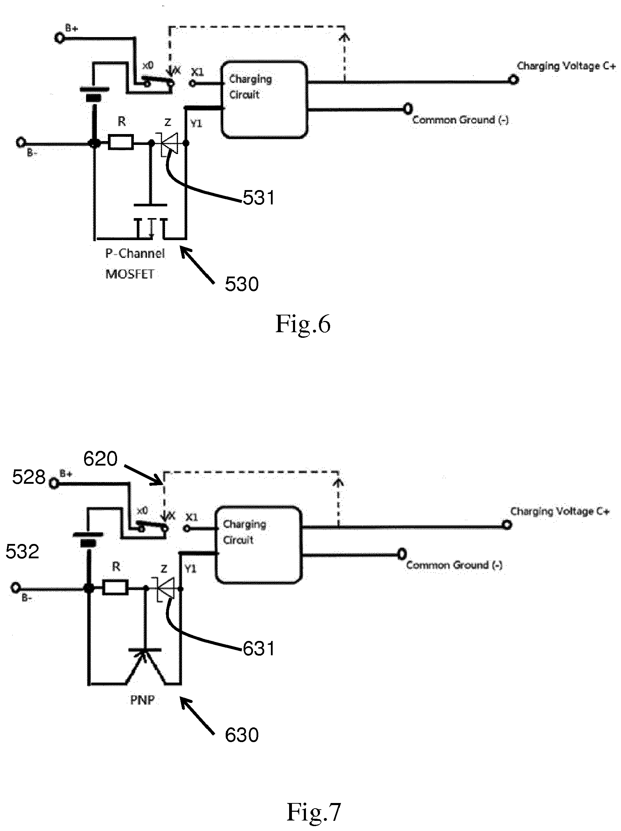

Turning to Fig. 6, in another embodiment of the invention a P-Channel MOSFET **530** is coupled with a Zener diode **531.** All other components in the battery module are the same as those in Fig. 4, and they will not be described in further details here. The Zener diode **531** is connected between the Drain pin and the Gate pin of the P-Channel MOSFET **530.** The operation of the battery module in Fig. 6 is similar to that of the battery module in Fig. 4 so it will not be described in details here. The Zener diode **531** is intended for protection of the P-Channel MOSFET **530** from damages due to connecting multiple similar battery modules in series. The Zener diode **531** does not affect the switch operation as described in Fig. 4.

Turning to Fig. 7, in another embodiment of the invention a PNP BJT **630** is coupled with a Zener diode **631.** All other components in the battery module are the same as those in Fig. 5, and they will not be described in further details here. The Zener diode **631** is connected between the Base pin and the Collector pin of the PNP BJT **630.** The operation of the battery module in Fig. 7 is similar to that of the battery module in Fig. 5 so it will not be described in details here. The Zener diode **631** is intended for protection of the PNP BJT **630** from damages due to connecting multiple similar battery modules in series. The Zener diode **631** does not affect the switch operation as described in Fig. 5.

The exemplary embodiments of the present invention are thus fully described. Although the description referred to particular embodiments, it will be clear to one skilled in the art that the present invention may be practiced with variation of these specific details. Hence this invention should not be construed as limited to the embodiments set forth herein.

While the invention has been illustrated and described in detail in the drawings and foregoing description, the same is to be considered as illustrative and not restrictive in character, it being understood that only exemplary embodiments have been shown and described and do not limit the scope of the invention in any manner. It can be appreciated that any of the features described herein may be used with any embodiment. The illustrative embodiments are not exclusive of each other or of other embodiments not recited herein. Accordingly, the invention also provides embodiments that comprise combinations of one or more of the illustrative embodiments described above. Modifications and variations of the invention as herein set forth can be made without departing from the spirit and scope thereof, and, therefore, only such limitations should be imposed as are indicated by the appended claims.

## Claims

1. A battery module, comprising:
a) a rechargeable battery;
b) a charging circuit for the rechargeable battery; and
c) a switch adapted to connect the rechargeable battery to the charging circuit, or to output terminals of the battery module;
wherein the switch is adapted to change its switching status by a voltage applied to input terminals of the charging circuit.

2. The battery module of claim 1, wherein the switch is a double-pole-double-throw (DPDT) type; two input terminals of the switch connecting to a positive terminal and a negative terminal of the rechargeable battery respectively; a first set of output terminals of the switch connecting to the output terminals of the battery module; a second set of output terminals of the switch connecting to output terminals of the charging circuit.

3. The battery module of claim 1, wherein the switch comprises a relay with an input connected to the input terminals of the charging circuit.

4. The battery module of claim 1, wherein the switch comprises a transistor circuit with an input connected to the input terminals of the charging circuit.

5. The battery module of claim 1, wherein the switch is a single-pole-double-throw (SPDT) type; an input terminal of the switch connecting to a positive terminal of the rechargeable battery; a first output terminal of the switch connecting to one of the output terminals of the module; a second output terminal of the switch connecting to one of the output terminals of the charging circuit; the battery module further comprising a transistor coupled between a negative terminal of the rechargeable battery and another one of the output terminals of the charging circuit.

6. The battery module of claim 5, wherein the transistor is a PNP BJT or a P-channel MOSFET.

7. The battery module of claim 5, wherein the transistor is coupled with a Zener diode.

8. A battery system, comprising a plurality of battery modules as defined in claim 1, wherein input terminals of a charging circuit in each said battery module are connected to a common input; output terminals of the plurality of battery modules connected in series or parallel.
